# EUROPEAN PATENT SPECIFICATION

(11) **EP 0 692 149 B1**
(45) Date of publication and mention of the grant of the patent: **02.06.1999**
(21) Application number: 94912920.9
(22) Date of filing: 31.03.1994
(51) Int. Cl.: H01R 23/70

(54) **ELECTRICAL CONNECTOR**
ELEKTRISCHER VERBINDER
CONNECTEUR ELECTRIQUE

(30) Priority: 31.03.1993 JP 15919/93
(43) Date of publication of application: 17.01.1996
(73) Proprietor: BERG ELECTRONICS MANUFACTURING B.V., 5222 AV s'-Hertogenbosch (NL)
(72) Inventor: SHU, Shinzui, Kawasaki-shi, Kanagawa-ken (JP)
(74) Representative: BROOKES & MARTIN
(86) International application number: US9403560
(87) International publication number: WO9423474

(56) References cited:
- EP-A- 0 351 985
- US-A- 3 932 934
- US-A- 4 583 807
- US-A- 4 802 862
- US-A- 4 802 862
- US-A- 4 850 902
- US-A- 5 029 748

## Description

### FIELD OF THE INVENTION

The present invention relates to an electrical connector and, in particular, to an electrical connector of a type solderable to a board such as a printed circuit board.

### BACKGROUND OF THE INVENTION

A method, referred to in the art as "hot riveting", is known for fixing an electrical connector to a printed circuit board. The hot riveting method involves the use of a connector housing comprising a housing body made of plastic and a plastic peg (leg) downwardly extending from the lower surface of the housing body. To fix the connector to the circuit board, the peg is inserted through a peg insertion bore in the printed circuit board until the lower surface of the housing body lies flat on the board surface. Then, the distal end of the peg, which protrudes from the insertion bore on the opposite side of the circuit board, is contacted with a mold taking surface of a heated mold pushing rod so as to melt and deform the peg. The mold taking surface of the mold pushing rod has a spherical recess with a greater diameter than that of the insertion bore in the board. As a result, the distal end of the peg is spherically deformed to a diameter greater than that of the insertion hole, thereby fixing the connector to the board.

Unfortunately, however, the peg does not always deform to the predetermined spherical shape of the mold taking surface due to the nonuniformity of heat conduction from the mold pushing rod to the peg or due to the non-uniformity, etc., of the inner mechanical properties of the peg resulting from the non-uniform hardness of the resin inside the peg. In such cases, the housing-to-board connection force becomes unstable, thus posing a reliability problem.

Additionally, with the prior art hot riveting method, it is often necessary to design or adjust the dimension of the peg in accordance with different insertion hole diameters in the board. The melting means, such as the mold pushing rod, must also be adjusted. Therefore, the manufacturing and mounting operations become more complex.

An object of the present invention is to provide an electrical connector which can readily and positively be fixed to a board, such as a printed circuit board, and can eliminate the necessity of providing any melting means, such as a mold pushing rod.

It is also another object of the present invention to provide an electrical connector which requires less design restriction to the peg and requires no adjustment of the peg.

US-A-4850902 describes an electrical connector with a housing for positioning on one side of a printed circuit board provided with a through hole. The housing is equipped with contact terminals and with a mounting post which passes through the hole and forms a snap-fit with the other side of the printed circuit board.

As is known from US-A-4850902, the present invention is concerned with an electrical connector to be automatically soldered to a circuit board having a through hole, said electrical connector comprising:
a housing body to be positioned on one side of the circuit board
a plurality of contact terminals arranged in the housing body; and
a plastic peg projecting from a surface of the housing body and adapted to project through the hole in the circuit board when the housing body is placed on said one side of the circuit board. In contrast to US-A-4850902, and in accordance with the invention, the peg is provided with solder means for securing the peg to the circuit board during a soldering step thereby fixing the electrical connector in place on the circuit board. When the housing body is placed on the surface of the board, the peg extends through the through hole in the board and protrudes outward from the opposite surface of the board. The protruding portion of the peg is then soldered to the board, thereby fixing the housing body to the board. In one embodiment the solder means is a solderable coating on the peg. In another embodiment the solder means is a cylindrical metal ring.

In another aspect the invention provides a method of fixing an electrical connector to a circuit board wherein said connector comprises a housing body with a plurality of contact terminals arranged on the housing body and having a peg of plastics material projecting from a surface thereof and wherein said circuit board has a through hole for receiving the peg, said method comprising the steps of:
a) positioning the electrical connector on one side of the circuit board such that said peg is inserted through said through hole.
b) providing a solder means in the form of a metal ring over said peg, and
c) applying a soldering operation to the opposite side of the circuit board whereby said metal ring fitted over said peg is soldered to said opposite side of the circuit board thereby fixing the electrical connector to the circuit board.

According to one embodiment of the present invention, the peg is soldered to the circuit board by means of a cylindrical metal ring fitted over the peg and through the through hole in the circuit board such that it occupies the space between the peg and the surface of the through hole. In another embodiment, the solder means may comprise a solderable coating formed on the peg. Preferably, the peg is soldered to the board during the same soldering step as the plurality of contact terminals.

Other features and advantages of the present invention will become evident hereinafter.

### BRIEF DESCRIPTION OF THE DRAWINGS

The foregoing summary, as well as the following detailed description of the preferred embodiments, is better understood when read in conjunction with the appended drawings. For the purpose of illustrating the invention, there is shown in the drawings embodiments that are presently preferred, it being understood, however, that the invention is not limited to the specific methods and instrumentalities disclosed. In the drawings:
FIG. 1 is a cross-sectional view showing an electrical connector according to a first embodiment of the present invention;
FIG. 2 is a perspective view showing a soldering side of the printed circuit board of FIG. 1;
FIG. 3 is an enlarged cross-sectional view of the cylindrical metal ring of FIG. 1;
FIG. 4 is a side view showing the electrical connector set in a soldering bath at an automatic soldering station;
FIG. 5 is a cross-sectional view showing a solder-connected area between an annular ring of the board and the cylindrical metal ring of the electrical connector of FIG. 4;
FIG. 6 is a perspective view showing a cylindrical metal ring in accordance with a second embodiment of the present invention:
FIG. 7 is a top view of the metal ring of FIG. 6;
FIG. 8 is a perspective view of a cylindrical metal ring in accordance with a third embodiment of the present invention; and
FIG. 9 is a top view of the metal ring of FIG. 8.

### DETAILED DESCRIPTION OF THE PREFERRED EMBODIMENTS

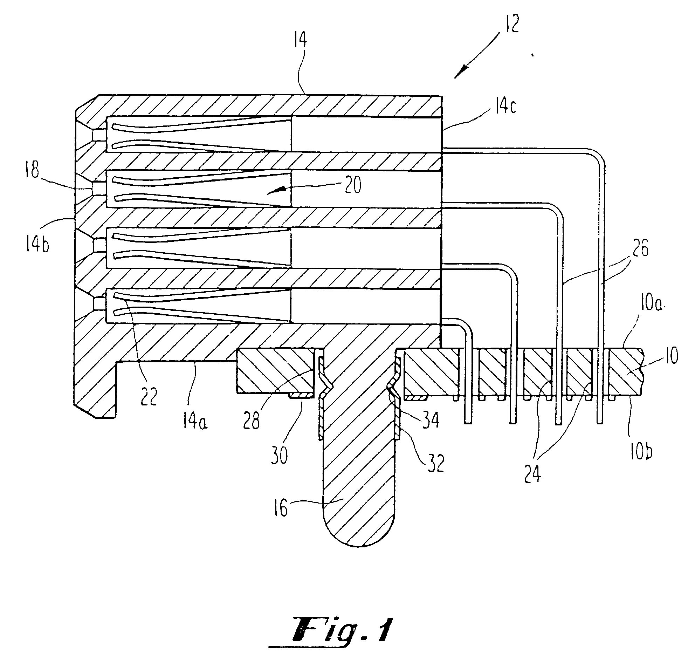

Referring to the drawings, FIG. 1 shows an electrical connector 12 in accordance with one embodiment of the present invention. Here, the electrical connector 12 comprises a receptacle connector (i.e., a female connector such as an outlet connector and socket) that is to be mounted on a main side 10a of a printed circuit board 10.

The receptacle connector 12 is equipped with a receptacle housing made of an electrically insulating resin material and connectable to a male plug connector (not shown). The receptacle housing is equipped with a housing body 14 of substantially rectangular configuration. The housing body 14 has a rod-like peg 16 formed integral with the housing body 14.

A front part of the lower surface 14a of the housing body 14 extends past an edge of the board 10, while the remaining portion of the lower surface 14a of the housing body 14 lies flat on the main side 10a of the board 10. A front wall 14b of the housing body 14 is situated substantially perpendicular to the lower surface 14a. The front wall 14b has openings 18 communicating with the -inside of the body 14. Solder tails 26, described hereinafter in greater detail, are projected from a rear wall 14c of the housing body 14.

A plurality of receptacle contacts 20 are arranged in corresponding openings 18. The receptacle contacts 20 have receptacle sections 22 for receiving plug contacts (not shown) of a male contact member (not shown) via the front wall 14b of the housing 14. The receptacle sections 22 may be designed so as to correspond to the configuration of the plug contacts, and are not restricted to the particular configuration shown. Each receptacle contact 20 further has a solder tail 26 that inserts into, and is subsequently soldered to, a corresponding through hole 24 of a circuit pattern on the printed circuit board 10.

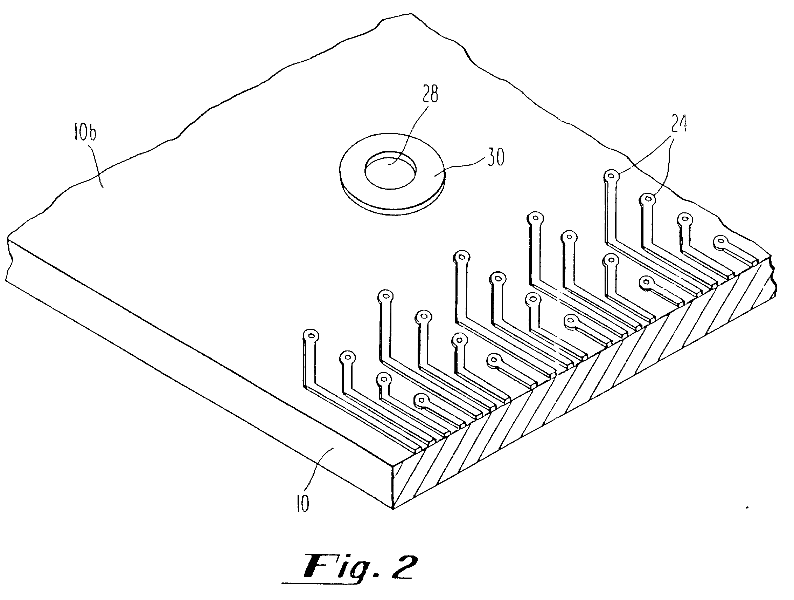

As further shown, the peg 16 projects vertically from the lower surface 14a of the housing body 14 and extends through an insertion hole 28. The distal end of the peg 16 protrudes outward from the hole 28 on the opposite, solder side 10b of the printed circuit board 10. As best shown in FIG. 2, an annular ring 30, which is made of a conductive material or a solderable material, is located around the peg insertion hole 28 on the solder side 10b of the board 10.

Referring back to FIG. 1, a substantially cylindrical metal ring 32 is fitted over the peg 16. A portion of the cylindrical metal ring 32 extends into the peg insertion hole 28 so as to be disposed between the peg 16 and the annular surface of the hole 28.

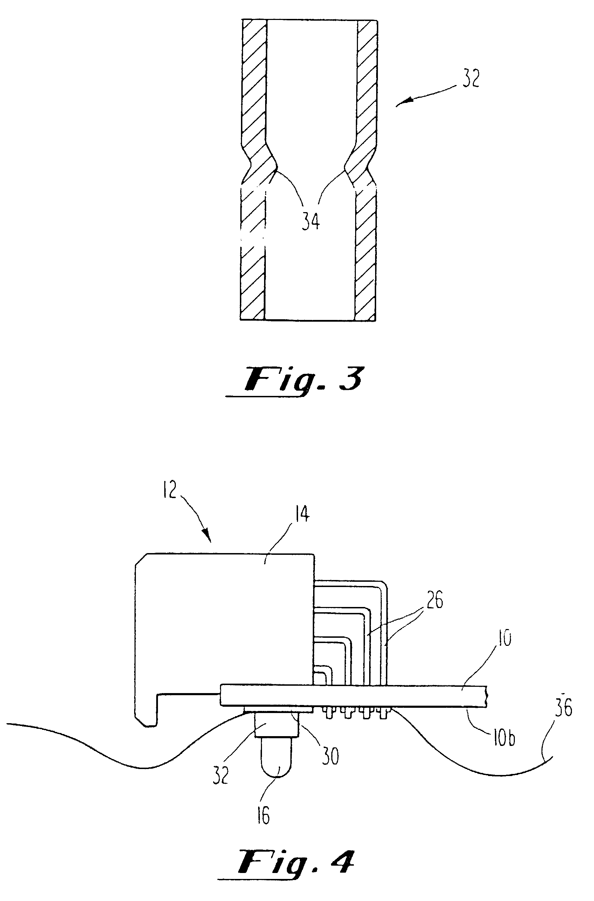

As shown in FIG. 3, an annular projection 34 is formed on the inner surface of the cylindrical metal ring 32 and extends toward the center axis of the cylindrical metal ring. It is desirable that the cross-sectional configuration of the annular projection 34 be, for example, V-shaped or wedge-shaped and have a projected end oriented toward the center axis of the cylindrical metal ring 32.

The cylindrical metal ring 32 has an outer diameter of a size insertable into the peg insertion hole 28. The inner diameter of the cylindrical metal ring 32 is of such a size as to allow the metal ring to be fitted over the peg 16. At the area of the annular projection 34, the inner diameter of the cylindrical metal ring 32 is made smaller than the outer diameter of the peg 16.

When the cylindrical metal ring 32 is press fitted over the peg 16, the area of the annular projection 34 on the cylindrical metal ring 32 receives a radial expansion force from the outer periphery of the peg 16 which acts against the normal tendency of the metal ring 32 to return, under its own elasticity, back to its original state. As a result of these opposing forces, the annular projection 34 bites into the peg 16 and hence the peg 16 is held in place. By so doing, the cylindrical metal ring 32 is fixed in place on the peg 16 and will not drop off the peg 16 under any slight oscillation or external force. If the cross-sectional shape of the annular projection is so formed as to have a pointed end as in the present embodiment, then the pointed end of the annular projection bites more forcibly into the peg 16, thus enabling it to be more firmly secured to the peg 16.

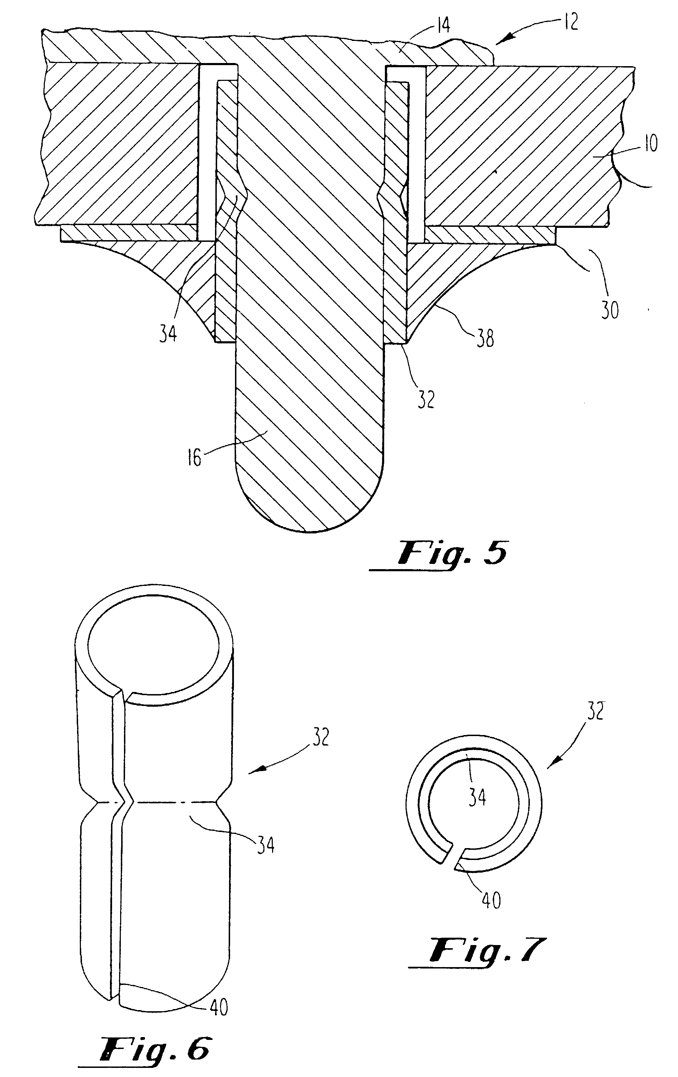

FIGS. 4 and 5 show the receptacle connector 12 in a soldering bath at an automatic soldering station. Here the solder tails 26 of the contacts 20 are inserted through the corresponding through holes 24 in the board 10 and the metal ring 32 is fitted over the peg 16. In the soldering bath, the solder side 10b of the board 10 is exposed to a molten solder wave 36 jetted in a wavy manner. By action of the solder wave 36, the solder tails 26 are soldered to their corresponding through holes 24. At the same time, a solder connection area 38 (Fig. 5) is formed between the angular ring 30 on the solder side 10b of the board 10 and the metal ring 32, thereby soldering the two together. During the soldering operation, the peg 16, being made of a resin material, is softened by heat (about 250 to 260°C) from the solder wave 36. As a result, the annular projection 34 on the inner surface of the metal ring 32 bites more forcibly into the peg 16, thus fixing the metal ring 32 to the peg 16 with a stronger force. The soldering of the annular ring 30 to the metal ring 32 firmly fixes the connector 12 to the board 10.

FIGS. 6 and 7 show a second embodiment of the present invention. This embodiment is similar to the first embodiment except that the structure of the metal ring 32 is different. In particular, in the second embodiment the metal ring 32 has a slit 40 along its axial direction. The slit 40 allows the metal ring 32 to expand more easily in the radial direction, thus facilitating the fitting of the metal ring 32 over the peg 16.

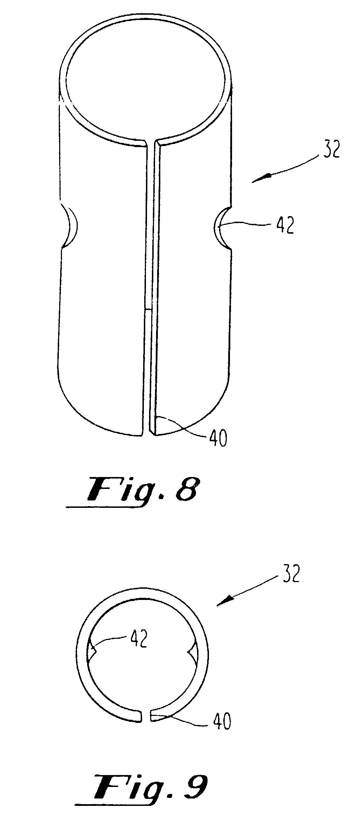

FIGS. 8 and 9 show a third embodiment of the present invention. The third embodiment differs from the first embodiment in that the metal ring 32 of the third embodiment has a plurality of projections 42, in place of the aforementioned annular projection 34, which are provided at given intervals along the inner wall of the metal ring 32. It is preferred that the cross-sectional shape of each projection 42 have a pointed end projected toward the center axis of the metal ring 32, such as a V-shaped or wedge-like end. Further a slit 40 may be provided as in the case of the second embodiment.

In the respective embodiments set out above, the receptacle connector 12 is fixed to the board 10 mainly by the metal ring 32, and the design tolerance can be more lenient for the peg 16. It is therefore easy to mold the housing body 14 integral with the peg 16.

If there is no particular design limitation on the peg 16, it may be possible to solder the peg 16 directly to the annular ring 30 of the board 10, instead of interposing the metal ring 32, by partially coating the peg 16 with a material with which the peg 16 can be soldered. Or it may be possible to manufacture the peg 16 itself from a solderable material. In this case, the housing body 14 and peg 16 are connected together by a proper method in place of being formed integral with each other. In the case where the peg 16 is made of a conductive material, it is of course necessary to electrically insulate the contacts 20 and peg 16 from each other. In any case, the softening of the peg 16 is achieved automatically by the soldering operation, and therefore, it is not necessary to use any melting means such as a conventional mold pushing rod.

Although in the aforementioned respective embodiments the receptacle connector 12 has been explained as being mounted on the printed circuit board 10, the present invention is not restricted thereto. The present invention can be applied to an electrical connector of any proper type necessary to be fixed to a board. Moreover, the shapes of the housing body and contacts are not limited to those disclosed in the Figures, nor are the shapes of the metal ring 32, projections 34, 42 and slit 40. It is understood, therefore, that changes may be made to the embodiments described above without departing from the broad inventive concepts thereof. Accordingly, this invention is not limited to the particular embodiments disclosed, but is intended to cover all modifications that are within the scope and spirit of the invention as defined by the appended claims.

## Claims

1. An electrical connector (12) to be automatically soldered to a circuit board (10) having a through hole (28), said electrical connector comprising:
a housing body (14) to be positioned on one side of the circuit board;
a plurality of contact terminals (20, 26) arranged in the housing body; and
a plastics peg (16) projecting from a surface of the housing body and adapted to project through the through hole (28) on the circuit board when the housing body is placed on said one side of the circuit board; characterized in that said peg (16) is provided with solder means (32) for securing said peg to the circuit board during a soldering step thereby fixing the electrical connector in place on the circuit board.

2. An electrical connector (12) according to claim 1 wherein said solder means is a cylindrical metal ring (32) adapted to fit over the peg (16) and through the through hole (28) when the housing body (14) is placed on the circuit board, said cylindrical metal ring (32) enabling soldering of the peg to the opposite side of the circuit board to fix the electrical connector in place on the circuit board.

3. An electrical connector according to claim 2, wherein the cylindrical metal ring (32) has a slit (40) formed therein along its axial direction to facilitate fitting the metal ring over the peg (16).

4. An electrical connector according to claim 2 or 3, wherein the cylindrical metal ring (32) has at least one projection (34,42) formed on an inner surface thereof, said at least one projection being adapted to bite into the peg (16) when the metal ring (32) is fitted over the peg, thereby fixing the ring (32) to the peg (16).

5. An electrical connector according to claim 4, wherein said at least one projection (34) comprises an annular projection formed about the inner surface of the cylindrical ring.

6. An electrical connector according to claim 4, wherein said at least one projection (42) comprises a plurality of separate projections spaced about the inner surface of the cylindrical metal ring (32).

7. An electrical connector according to claim 4, 5 or 6, wherein said at least one projection (34, 42) is V-shaped.

8. An electrical connector according to claim 1, wherein said solder means comprises a solderable coating formed on said peg.

9. An electrical connector according to any one of claims 1 to 8, wherein said peg (16) is formed integrally with said housing body (14).

10. A method of fixing an electrical connector (12) to a circuit board (10) wherein said connector comprises a housing body (14) having a peg (16) of plastics material projecting from a surface thereof and wherein said circuit board (10) has a through hole (28), said method comprising the steps of:
a) positioning the electrical connector (12) on one side of the circuit board (10) such that said peg (16) is inserted through said through hole (28);
b) providing a solderable means in the form of a metal ring (32) over said peg (16), and
c) applying a soldering operation to the opposite side of the circuit board whereby said metal ring (32) fitted over said peg (16) is soldered to said opposite side of the circuit board thereby fixing the electrical connector to the circuit board.

11. A method according to claim 10, wherein said metal ring (32) comprises a cylindrical metal ring with a slit (40) formed therein along its axial direction and at least one projection (34, 42) formed on an inner surface thereof and the fitting step involves placing the metal ring (32) onto the peg (16) and pressing the ring (32) onto the peg (16) so that the projection (34) bites into the peg (16).

## Patentansprüche

1. Elektrischer Verbinder (12) zum automatischen Anlöten an eine Leiterplatte (10) mit einem Durchgangsloch (28), wobei der elektrische Verbinder umfaßt:
einen an einer Seite der Leiterplatte zu positionierenden Gehäusekörper (14),
eine Mehrzahl von in dem Gehäusekörper angeordneten Kontaktanschlüssen (20, 26), und
ein Kunststoffstift (16), welcher von einer Oberfläche des Gehäusekörpers hervorsteht und dazu ausgebildet ist, durch das Durchgangsloch (28) an der Leiterplatte hindurchzuragen, wenn der Gehäusekörper an der einen Seite der Leiterplatte angeordnet ist,
dadurch gekennzeichnet, daß der Stift (16) mit einem Lötmittel (32) versehen ist zum Festlegen des Stifts an der Leiterplatte während eines Lötschrittes, um dadurch den elektrischen Verbinder an der Leiterplatte zu fixieren.

2. Elektrischer Verbinder (12) nach Anspruch 1, worin das Lötmittel ein elektrischer Metallring (32) ist, welcher zur Passung über den Stift (16) und durch das Durchgangsloch (28) hindurch ausgebildet ist, wenn der Gehäusekörper (14) an der Leiterplatte angeordnet ist, wobei der zylindrische Metallring (32) das Anlöten des Stifts an die entgegengesetzte Seite der Leiterplatte ermöglicht, um den elektrischen Verbinder an der Leiterplatte zu fixieren.

3. Elektrischer Verbinder nach Anspruch 2, worin der zylindrische Metallring (32) einen entlang seiner axialen Richtung darin ausgebildeten Schlitz (40) aufweist, um das Passen des Metallrings über den Stift (16) zu erleichtern.

4. Elektrischer Verbinder nach Anspruch 2 oder 3, worin der zylindrische Metallring (32) wenigstens einen an einer Innenoberfläche desselben ausgebildeten Vorsprung (34, 42) aufweist, wobei der wenigstens eine Vorsprung dazu ausgebildet ist, in den Stift (16) einzuschneiden, wenn der Metallring (32) über den Stift gepaßt ist, wodurch der Ring (32) an dem Stift (16) fixiert ist.

5. Elektrischer Verbinder nach Anspruch 4, worin der wenigstens eine Vorsprung (34) einen um die Innenoberfläche des zylindrischen Rings herum ausgebildeten ringförmigen Vorsprung umfaßt.

6. Elektrischer Verbinder nach Anspruch 4, worin der wenigstens eine Vorsprung (42) eine Mehrzahl von separaten Vorsprüngen umfaßt, welche um die Innenoberfläche des zylindrischen Metallrings (32) herum mit Abstand angeordnet sind.

7. Elektrischer Verbinder nach Anspruch 4, 5 oder 6, worin der wenigstens eine Vorsprung (34, 42) V-förmig ist.

8. Elektrischer Verbinder nach Anspruch 1, worin das Lötmittel eine an dem Stift gebildete lötbare Beschichtung umfaßt.

9. Elektrischer Verbinder nach einem der Ansprüche 1 bis 8, worin der Stift (16) mit dem Gehäusekörper (14) integral ausgebildet ist.

10. Verfahren zum Festlegen eines elektrischen Verbinders (12) an einer Leiterplatte (10), worin der Verbinder einen Gehäusekörper (14) mit einem Stift (16) aus Kunststoffmaterial umfaßt, welcher von einer Oberfläche desselben hervorsteht, und worin die Leiterplatte (10) ein Durchgangsloch (28) aufweist, worin das Verfahren die Schritte umfaßt:
a) Positionieren des elektrischen Verbinders (12) an einer Seite der Leiterplatte (10) derart, daß der Stift (16) durch das Durchgangsloch (28) hindurchgeführt wird,
b) Vorsehen eines lötbaren Mittels in der Form eines Metallrings (32) über dem Stift (16), und
c) Durchführen eines Lötvorgangs an der entgegengesetzten Seite der Leiterplatte, wodurch der über den Stift (16) gepaßte Metallring (32) an die entgegengesetzte Seite der Leiterplatte angelötet wird, um dadurch den elektrischen Verbinder an der Leiterplatte zu fixieren.

11. Verfahren nach Anspruch 10, worin der Metallring (32) einen zylindrischen Metallring mit einem darin entlang seiner axialen Richtung ausgebildeten Schlitz (40) und wenigstens einem Vorsprung (34, 42) umfaßt, welcher an einer Innenoberfläche desselben ausgebildet ist, und worin der Paß-Schritt das Plazieren des Metallrings (32) auf dem Stift (16) und das Pressen des Rings (32) auf den Stift (16) umfaßt, so daß der Vorsprung (34) in den Ring (16) einschneidet.

## Revendications

1. Connecteur électrique (12) à souder automatiquement à une carte de circuit (10) possédant un trou traversant (28), ledit connecteur électrique comprenant :
un corps de logement (14) à disposer d'un côté de la carte de circuit;
une pluralité de bornes de contact (20,26) disposées dans le corps de logement; et
une cheville de matière plastique (16) se projetant à partir d'une surface du corps de logement et à adapter en vue de se projeter à travers le trou traversant (28) sur la carte de circuit lorsque le corps de logement est placé sur ledit un côté de la carte de circuit; caractérisé en ce que ladite cheville (16) est munie d'un moyen de soudure (32) afin de fixer fermement ladite cheville à la carte de circuit au cours d'une étape de soudage fixant ainsi le connecteur électrique en place sur la carte de circuit.

2. Connecteur électrique (12) selon la revendication 1, dans lequel ledit moyen de soudure est une bague métallique cylindrique (32) adaptée afin de s'ajuster sur la cheville (16) et à travers le trou traversant (28) lorsque le corps de logement (14) est placé sur la carte de circuit, ladite bague métallique cylindrique (32) permettant de souder la cheville au côté opposé de la carte de circuit afin de fixer le connecteur électrique en place sur la carte de circuit.

3. Connecteur électrique selon la revendication 2, dans lequel la bague cylindrique métallique (32) possède une fente (40) formée dans celui-ci le long de sa direction axiale afin de faciliter le positionnement de la bague métallique sur la cheville (16).

4. Connecteur électrique selon la revendication 2 ou 3, dans lequel la bague métallique cylindrique (32) possède au moins une projection (34,42) formée sur une surface interne de celle-ci, ladite au moins une projection étant adaptée afin de mordre la cheville (16) lorsque la bague métallique (32) est positionnée sur la cheville, fixant ainsi la bague (32) à la cheville (16).

5. Connecteur électrique selon la revendication 4, dans lequel au moins une projection (34) constitue une projection annulaire formée autour de la surface interne de la bague cylindrique.

6. Connecteur électrique selon la revendication 4, dans lequel ladite au moins une projection (42) comprend une pluralité de projections séparées espacées autour de la surface interne de la bague métallique cylindrique (32).

7. Connecteur électrique selon la revendication 4, 5 ou 6, dans lequel ladite au moins une projection (34,42) est en forme de V.

8. Connecteur électrique selon la revendication 1, dans lequel ledit moyen de soudure comprend un revêtement soudable formé sur la dite cheville.

9. Connecteur électrique selon les revendications 1 à 8, dans lequel ladite cheville (16) fait partie intégrante dudit corps de logement (14).

10. Procédé de fixation d'un connecteur électrique (12) à une carte de circuit (10), dans lequel ledit connecteur comprend un corps de logement (14) ayant une cheville (16) de matière plastique se projetant d'une surface de celui-ci et dans lequel ladite carte de circuit (10) possède un trou traversant (28), ledit procédé comprenant les étapes consistant:
a) à disposer le connecteur électrique (12) d'un côté de la carte de circuit (10) de sorte que ladite cheville (16) est insérée à travers ledit trou traversant (28);
b) à fournir un moyen soudable sous forme d'une bague métallique (32) sur ladite cheville (16), et
c) à mettre en oeuvre une opération de soudage du côté opposé de la carte de circuit par laquelle ladite bague métallique (32) est conditionnée sur ladite cheville (16) et soudée audit côté opposé de la carte de circuit fixant ainsi le connecteur électrique à la carte de circuit.

11. Procédé selon la revendication 10, dans lequel ladite bague métallique (32) comprend une bague métallique cylindrique ayant une fente (40) formée dans celle-ci le long de sa direction axiale et au moins une projection (34,42) formée sur une surface interne de celle-ci et l'étape de positionnement consiste à placer la bague métallique (32) sur la cheville (16) et à presser la bague (32) sur la cheville (16) de sorte que la projection (34) morde la cheville (16).
